**Europäisches Patentamt**

**European Patent Office**

**Office européen des brevets**

(19)

(11) Numéro de publication: **0 112 242**
**B1**

(12)

# FASCICULE DE BREVET EUROPEEN

(45) Date de publication du fascicule du brevet:
27.08.86

(51) Int. Cl.⁴: **G 01 R 31/36, H 01 M 10/48**

(21) Numéro de dépôt: **83402361.6**

(22) Date de dépôt: **06.12.83**

(54) Dispositif de contrôle de la capacité d'une batterie d'éléments d'accumulateur.

(30) Priorité: **13.12.82 FR 8220859**

(43) Date de publication de la demande:
**27.06.84 Bulletin 84/26**

(45) Mention de la délivrance du brevet:
**27.08.86 Bulletin 86/35**

(84) Etats contractants désignés:
**BE DE GB IT**

(56) Documents cités:
**DE - B - 2 842 817**
**GB - A - 2 086 060**
**US - A - 3 786 343**
**US - A - 4 280 097**

(73) Titulaire: **ELECTRICITE DE FRANCE Service National, 2, rue Louis Murat, F-75008 Paris (FR)**

(72) Inventeur: **Vandenberghe, Claude, 25 rue Varlet, F-02100 St. Quentin (FR)**
Inventeur: **Le Morvan, André, 65 rue Michelet, F-02100 St.Quentin (FR)**

(74) Mandataire: **Martin, Jean-Jacques et al, Cabinet REGIMBEAU 26, Avenue Kléber, F-75116 Paris (FR)**

## Description

La présente invention concerne un dispositif de contrôle de la capacité d'une batterie d'éléments d'accumulateur reliés en série et déchargés de manière continue, notamment pour les batteries d'accumulateur installées dans les postes de distribution.

Les règlementations en vigueur font obligation de vérifier périodiquement la capacité de ces batteries. Cette vérification est opérée en déchargeant la batterie de manière continue au moyen d'un rhéostat monté aux bornes de la batterie, de façon à régler l'intensité de décharge à une valeur constante.

On arrête la décharge de chaque élément de la batterie, par déconnexion de celui-ci, dès que sa tension individuelle est inférieure à un seuil donné. On continue alors la décharge des autres éléments en maintenant toujours l'intensité constante.

En même temps, on note le temps de décharge de l'élément correspondant. Cette valeur étant connue ainsi que celle de l'intensité de décharge, il est possible de déterminer la quantité d'électricité restituée par l'élément de batterie, c'est-à-dire la capacité de celui-ci.

La procédure actuelle est cependant fastidieuse et dangereuse: elle est tout d'abord fastidieuse car l'opérateur doit mesurer de façon continuelle, à l'aide d'un voltmètre, la tension aux bornes de chacun des éléments de la batterie, et ceci pendant toute la durée de la décharge. La durée du cycle de décharge est longue (de l'ordre de 5 à 10 heures), et le nombre d'éléments à contrôler individuellement est élevé (par exemple, les batteries généralement utilisées de 48 volts et 127 volts comportent respectivement 24 et 58 éléments).

La procédure est également dangereuse, dans la mesure où l'opérateur travaille continuellement sur un dispositif présentant à ses bornes extrêmes une tension dangereuse (48 ou 127 volts) et doit donc faire ses mesures muni de gants de protection.

L'objet de la présente invention est de s'affranchir de cette mesure manuelle, en permettant d'interrompre la décharge de la batterie et d'avertir l'opérateur dès que l'un des éléments individuels se trouve déchargé, c'est-à-dire lorsque la tension à ses bornes devient inférieure au seuil prédéterminé. Le dispositif de l'invention permet d'indiquer celui des éléments qui se trouve déchargé, ainsi que le temps de décharge écoulé depuis le début de la mesure. L'opérateur peut alors déconnecter l'élément en cause, noter le temps de décharge correspondant, et donner au dispositif un ordre de reprise de l'opération de décharge, jusqu'à ce que le dispositif détecte la décharge d'un autre élément individuel.

Le cycle continue ainsi jusqu'au dernier élément déchargé de la batterie.

Pour cela, le dispositif selon l'invention comporte:

des moyens séquenceurs pour adresser cycliquement chacun des éléments de la batterie, aptes à délivrer un signal de mesure unique représentatif de la tension aux bornes de l'élément adressé,

des moyens comparateurs, aptes à délivrer un signal de sortie lorsque la tension représentée par le signal de mesure devient inférieure à une tension de seuil correspondant à la fin de la décharge de l'élément.

Un tel ensemble de surveillance multiplexée d'un ensemble de batteries est déjà en lui-même connu (cf. par exemple le US-A-3786343).

Pour atteindre le but visé ci-dessus, l'invention prévoit de combiner cet ensemble avec:

des moyens formant chronomètre, coopérant avec les moyens comparateurs de manière à indiquer la durée de décharge de l'élément pour lequel un signal de sortie a été délivré,

des moyens inhibiteurs pour suspendre le fonctionnement cyclique des moyens séquenceurs lorsque les moyens comparateurs détectent le franchissement du seuil, ainsi que

des moyens indicateurs de l'élément adressé par les moyens séquenceurs.

Le dispositif peut également comporter des moyens de validation permettant d'autoriser la reprise du fonctionnement des moyens séquenceurs après suspension par les moyens inhibiteurs.

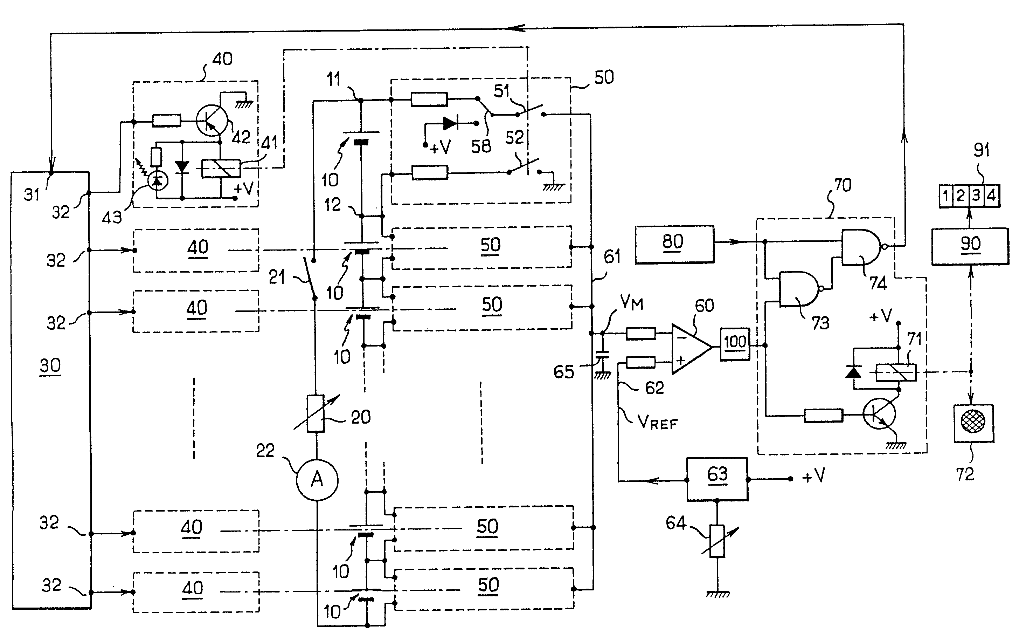

D'autres caractéristiques et avantages de l'invention apparaîtront à la lecture de la description détaillée ci-dessous, faite en référence à la figure unique annexée représentant schématiquement le dispositif de l'invention.

La batterie est constituée d'une série d'éléments individuels 10 disposés en série, l'ensemble étant relié à un rhéostat 20 de décharge par l'intermédiaire d'un commutateur 21 (normalement ouvert au repos). Un ampère-mètre 22 permet de régler l'intensité de décharge à une valeur constante.

A titre d'exemple, on considèrera une batterie de tension nominale 127 volts, composée de 58 éléments en série. La tension nominale de chaque élément est d'environ 2,2 volts et l'élément sera considéré comme déchargé lorsque la tension à ses bornes atteindra le seuil de 1,8 volt.

Pour une batterie de 127 volts de capacité 100 A.h, le temps de décharge est de l'ordre de 5 heures sous une intensité constante de 20 A.

Le circuit séquenceur est constitué d'un compteur en anneau 30 alimenté, sur son entrée 31, par des impulsions provenant d'un circuit d'horloge 80, délivrant par exemple des impulsions toutes les 24 millisecondes.

Les sorties 32 du compteur en anneau vont être cycliquement et successivement activées. Aux bornes de chacune de ces sorties, on prévoit un circuit 40 de commande, composé d'un relais 41 piloté par un transistor 42.

Ces relais assurent un isolement galvanique total entre les circuits de commande 40 et les circuits de mesure 50: un circuit 50 est prévu aux bornes 11, 12 de chacun des éléments 10; les contacts 51 et 52 du relais 41, normalement ouverts en l'absence d'excitation du relais, mettent en communication les bornes de l'élément de batterie adressé par le circuit séquenceur avec une ligne omnibus 61 reliée à l'entrée inverseuse d'un circuit comparateur 60.

Par ailleurs, l'activation du relais 41 provoque également l'allumage d'une diode électro-luminescente 43 placée aux bornes du relais 41: l'allumage de cette diode indique donc l'élément adressé par le circuit séquenceur, sur lequel est donc opérée la mesure.

La tension $V_M$ présente sur la ligne omnibus 61 est donc une tension multiplexée représentative, successivement, de la tension aux bornes de chacun des éléments.

La seconde entrée 62 du comparateur 60 est maintenue à une tension constante de référence $V_{REF}$ représentative de la tension de seuil correspondant à la décharge d'un élément individuel (dans notre exemple, cette tension est de 1,8 volt).

Cette tension est obtenue à partir de la tension d'alimentation V au moyen d'un régulateur intégré 63 réglé par une résistance ajustable 64.

La condensateur 65 placé entre l'entrée inverseuse du comparateur et la masse agit en mémoire temporaire pour éviter les brusques variations de la tension multiplexée à chaque pas du circuit séquenceur.

La sortie du comparateur 60 (qui est donc activée lorsque la tension de l'élément en cause devient inférieure à la tension de seuil) commande, par l'intermédiaire d'un monostable 100, un circuit 70.

Ce circuit comprend d'abord un relais 71 pouvant d'une part actionner une alarme 72 pour avertir l'opérateur, qui pourra ouvrir l'interrupteur 21, interrompant ainsi la décharge de la batterie. Par ailleurs, la sortie du comparateur 60 est reliée à deux portes NON-ET en cascade. L'apparition d'un signal en sortie du comparateur a pour effet de bloquer les impulsions d'horloge issues du circuit 80. Le compteur en anneau 30, qui utilise ces impulsions, voit donc son fonctionnement interrompu. Le relais 71 suspend également le fonctionnement du chronomètre 90: l'affichage 91 indique donc le temps écoulé depuis le début de la décharge.

Enfin, chaque circuit 50 comporte un commutateur 58, actionnable par l'opérateur, pour mettre en permanence à une tension positive continue V, supérieure à la tension de seuil, la sortie correspondante du circuit de mesure.

Le fonctionnement du dispositif est le suivant: initialement, tout les éléments 10 sont reliés en série et se déchargent dans le rhéostat 20, que l'opérateur règle pour obtenir un courant de décharge constant. Les relais 41 sont actionnés successivement par le circuit séquenceur et, tant qu'aucun élément n'a sa tension inférieure à la tension de seuil, le comparateur ne produit aucun signal en sortie: les portes 73, 74 restent passantes et le chronomètre 90 continue à fonctionner.

Lorsque la tension de l'un des éléments descend en dessous du seuil prédéterminé, la sortie du comparateur est activée et bloque la transmission des impulsions de l'horloge 80, ce qui suspend le fonctionnement du séquenceur 30. Par ailleurs, le relais 71 est actionné, ce qui déclenche l'alarme 70 et suspend le fonctionnement du chronomètre.

L'opérateur repère alors celle des diodes 57 qui est allumée, indiquant l'élément ayant provoqué l'arrêt du dispositif. Il peut alors, après avoir débranché provisoirement le rhéostat pour suspendre la décharge, déconnecter cet élément, et, pour relancer le fonctionnement du dispositif, ferme l'interrupteur 58, appliquant ainsi de façon continue une tension plus élevée que la tension de seuil à l'entrée du comparateur.

La sortie de celui-ci est alors désactivée, ce qui a pour effet de:

arrêter l'alarme 72,

reprendre le fonctionnement cyclique du séquenceur 30 (les portes 73, 74 étant rendues passantes),

reprendre le comptage du temps par le chronomètre 90.

L'opérateur referme alors manuellement l'interrupteur 21 pour retrancher le rhéostat et poursuivre la décharge.

L'exploration cyclique des différents éléments restant en circuit continuera ainsi jusqu'à la rencontre d'un nouvel élément déchargé. On notera que le circuit 50 correspondant à l'élément précédemment déconnecté ne perturbe pas le déroulement du cycle d'exploration, grâce à la tension continue appliquée par l'interrupteur 58, qui demeure fermé.

**Revendications**

Dispositif de contrôle de la capacité d'une batterie d'éléments (10) d'accumulateur reliés en série et déchargés de manière continue, du type comportant:

des moyens séquenceurs (30, 40, 50) pour adresser cycliquement chacun des éléments de la batterie, aptes à délivrer un signal de mesure ($V_M$) unique représentatif de la tension aux bornes de l'élément adressé,

des moyens comparateurs (60), aptes à délivrer un signal de sortie lorsque la tension ($V_M$) représentée par le signal de mesure devient inférieure à une tension de seuil ($V_{REF}$) correspondant à la fin de la décharge de l'élément,

caractérisé en ce qu'il comporte en outre:

des moyens formant chronomètre (90, 91), coopérant avec les moyens comparateurs de manière à indiquer la durée de décharge de l'élément pour lequel un signal de sortie a été délivré,

des moyens inhibiteurs (70) pour suspendre le fonctionnement cyclique des moyens séquenceurs (30) lorsque les moyens comparateurs délivrent un signal de sortie, ainsi que

des moyens indicateurs (43) de l'élément adressé par les moyens séquenceurs.

2. Dispositif selon la revendication 1, caractérisé en ce que les moyens séquenceurs comprennent un compteur en anneau (30) alimenté par des impulsions délivrées par un circuit d'horloge (80).

3. Dispositif selon la revendication 2, caractérisé en ce que les moyens inhibiteurs suspendent également la délivrance des impulsions par le circuit d'horloge.

4. Dispositif selon l'une des revendications 1 à 3, caractérisé en ce qu'il comporte également des moyens de validation (58) aptes à autoriser la reprise du fonctionnement des moyens séquenceurs après suspension par les moyens inhibiteurs.

5. Dispositif selon la revendication 4, caractérisé en ce que les moyens de validation sont des moyens permettant de substituer au signal de mesure un signal permanent représentatif d'une tension (V) supérieure à la tension de seuil ($V_{REF}$).

6. Dispositif selon l'une des revendications 1 à 5, caractérisé en ce que les moyens séquenceurs comportent une série de relais (41) actionnés cycliquement et assurant chacun la liaison entre les bornes (11, 12) de l'élément de batterie adressé et l'entrée correspondante (61) du comparateur.

7. Dispositif selon la revendication 6, caractérisé en ce que la commutation de chaque relais assure en outre, simultanément, l'allumage d'un témoin lumineux (43) formant moyen indicateur.

## Patentansprüche

1. Anordnung zum Überprüfen der Leistungsfähigkeit einer Batterie von Akkumulatorelementen (10), die in Reihe liegen und kontinuierlich entladbar sind, mit:
Folgesteuergliedern (30, 40, 50) zum zyklischen Adressieren jedes Akkumulatorelements der Batterie, wobei die Folgesteuerglieder ein Messsignal ($V_M$) zu liefern vermögen, das jeweils die Spannung an den Klemmen des adressierten Akkumulatorelements darstellt,
Vergleichseinrichtungen (60), die ein Ausgangssignal abzugeben vermögen, sobald die durch das Messsignal dargestellte Spannung ($V_M$) niedriger wird als eine Schwellenwertspannung ($V_{REF}$) entsprechend dem Ende der Entladung des Akkumulatorelements,
gekennzeichnet durch
einen Zeitgeber (90, 91) bildende Einrichtungen, die mit den Vergleichereinrichtungen zusammenwirken, um die Entladungszeitdauer des Akkumulatorelements anzuzeigen, für das ein Ausgangssignal abgegeben wurde,
Sperrglieder (70) zum Einstellen des zyklischen Betriebs der Folgesteuerglieder (30), wenn die Vergleichereinrichtungen ein Ausgangssignal abgeben sowie Anzeigeeinrichtungen (43) für das durch die Folgesteuerglieder adressierte Akkumulatorelement.

2. Anordnung nach Anspruch 1, dadurch gekennzeichnet, dass die Folgesteuerglieder einen Ringzähler (30) aufweisen, der durch von einem Taktgeber (80) gelieferte Impulse versorgt ist.

3. Anordnung nach Anspruch 2, dadurch gekennzeichnet, dass die Sperrglieder in gleicher Weise die Abgabe der Impulse durch den Taktgeber aussetzen.

4. Anordnung nach einem der Ansprüche 1 bis 3, gekennzeichnet durch Betätigungsglieder (58), die die Wiederaufnahme des Betriebs der Folgesteuerglieder nach Aussetzen durch die Sperrglieder zuzulassen vermögen.

5. Anordnung nach Anspruch 4, dadurch gekennzeichnet, dass die Betätigungsglieder Mittel umfassen, das Messsignal durch ein Dauersignal zu ersetzen, das eine über der Schwellenwertspannung ($V_{REF}$) liegende Spannung (V) darstellt.

6. Anordnung nach einem der Ansprüche 1 bis 5, dadurch gekennzeichnet, dass die Folgesteuerglieder eine Reihe von Relais (41) aufweisen, die zyklisch betätigbar sind und jeweils eine Verbindung zwischen den Klemmen (11, 12) des adressierten Akkumulatorelements der Batterie und den entsprechenden Eingang (61) des Vergleichers gewährleisten.

7. Anordnung nach Anspruch 6, dadurch gekennzeichnet, dass die Umschaltung jedes Relais ausserdem gleichzeitig die Beleuchtung einer die Anzeigeeinrichtung bildenden Lichtmarke (43) gewährleistet.

## Claims

1. An arrangement for testing the capacity of a battery of series-connected, continuously discharged storage cells (10), of the type comprising:
sequencing means (30, 40, 50) for sequentially adressing each of the cells of the battery adapted to deliver a single measuring signal ($V_M$) representative of the voltage at the terminals of the adressed cell,
comparator means (60) adapted to deliver an output signal when the voltage ($V_M$) represented by the measuring signal falls below a threshold voltage ($V_{REF}$) corresponding to the end of discharge of the cell,
characterized in that it additionally comprises
stopwatch means (90, 91) co-operating with the comparator means to indicate the discharge time of the cell for which an output signal has been delivered,
inhibitor means (70) for suspending the sequential operation of the sequencing means (30) when the comparator means deliver an output signal, and
indicator means (43) for the cell addressed by the sequencing means.

2. An arrangement as claimed in claim 1, characterized in that the sequencing means comprise a ring counter (30) fed by pulses delivered by a clock circuit (80).

3. An arrangement as claimed in claim 2, characterized in that the inhibitor means also suspend delivery of the pulses by the clock circuit.

4. An arrangement as claimed in any of claims 1 to 3, characterized in that it also comprises validating means (58) adapted to allow the resumption of operation of the sequencing means after suspension by the inhibitor means.

5. An arrangement as claimed in claim 4, characterized in that the validating means are means which enable the measuring signal to be substituted for a constant signal representative of a voltage (V) higher than the threshold voltage ($V_{REF}$).

6. An arrangement as claimed in any of claims 1 to 5, characterized in that the sequencing means comprise a series of sequentially actuated relays (41) each of which establishes the connection between the terminals (11, 12) of the battery cell addressed and the corresponding input (61) of the comparator.

7. An arrangement as claimed in claim 6, characterized in that the switching of each relay simultaneously results in the illumination of a telltale lamp (43) forming an indicator means.